# EUROPEAN PATENT SPECIFICATION

(11) **EP 1 050 958 B1**
(45) Date of publication and mention of the grant of the patent: **16.01.2008**
(21) Application number: 00401249.8
(22) Date of filing: 05.05.2000
(51) Int. Cl.: H03H 7/01

(54) **Stacked LC filter**
Gestapeltes LC-Filter
Filtre LC à empilement

(30) Priority: 07.05.1999 JP 12782099
(43) Date of publication of application: 08.11.2000
(73) Proprietor: MURATA MANUFACTURING CO., LTD., Nagaokakyo-shi, Kyoto 617-8555 (JP)
(72) Inventor: Kato, Noboru, c/o (A170) Intel. Property Dep., Nagaokakyo-shi, Kyoto-fu 617-8555 (JP)
(74) Representative: Thévenet, Jean-Bruno

(56) References cited:
- EP-A- 0 844 625
- US-A- 5 404 118
- PATENT ABSTRACTS OF JAPAN vol. 1997, no. 12, 25 December 1997 (1997-12-25) & JP 09 214274 A (MURATA MFG CO LTD), 15 August 1997 (1997-08-15)
- PATENT ABSTRACTS OF JAPAN vol. 017, no. 347 (E-1391), 30 June 1993 (1993-06-30) & JP 05 048365 A (MURATA MFG CO LTD), 26 February 1993 (1993-02-26)

## Description

### BACKGROUND OF THE INVENTION

### 1. Field of the Invention

The present invention relates to LC filters, and more particularly relates to a stacked LC filter for use at high frequencies.

### 2. Description of the Related Art

Below, references to specific directions (e.g. «front», «back», «left» and «right») refer to the devices when oriented as shown in the respective figures.

As a three or more stage band-pass filter allowing a signal in a particular frequency band to pass through it, for example, a circuit construction thereof is as shown in Fig. 8. The band-pass filter is a three-stage band-pass filter which is constituted of a first stage resonator Q1, a second stage resonator Q2 and a third stage resonator Q3. These LC resonators Q1 to Q3 are electrically coupled via coupling capacitors Cs1 and Cs2 between neighboring resonators.

Hitherto, as a stacked band-pass filter having the above-described circuit construction, the one shown in, for example, Figs. 9 to 11 is known. An LC filter 1 is formed in which the first stage to the third stage LC resonators Q1 to Q3 are formed in a layered body 21 formed by stacking quadrangular ceramic sheets 2 and constitute the equivalent circuit shown in Fig. 8.

Inductors L1 to L3 of the LC resonators Q1 to Q3 are formed using inductor patterns 3, 4, and 5, respectively. Capacitors C1 to C3 of the LC resonators Q1 to Q3 are formed using capacitor patterns 9, 10, and 11, and edge parts 6, 7, and 8 of the inductor patterns 3, 4, and 5 which face the capacitor patterns 9, 10, and 11, respectively. The above LC resonators Q1 to Q3 are electrically coupled via the coupling capacitors Cs1 and Cs2 which are formed using the capacitor patterns 9 to 11 and coupling capacitor patterns 12 and 13 facing these capacitor patterns 9 to 11. These LC resonators Q1 and Q3 are capacitively-coupled with an input capacitor pattern 14 and an output capacitor pattern 15, respectively. Shielding patterns 16a and 16b are provided so that these inductor patterns 3 to 5 and capacitor patterns 9 to 15 are held therebetween.

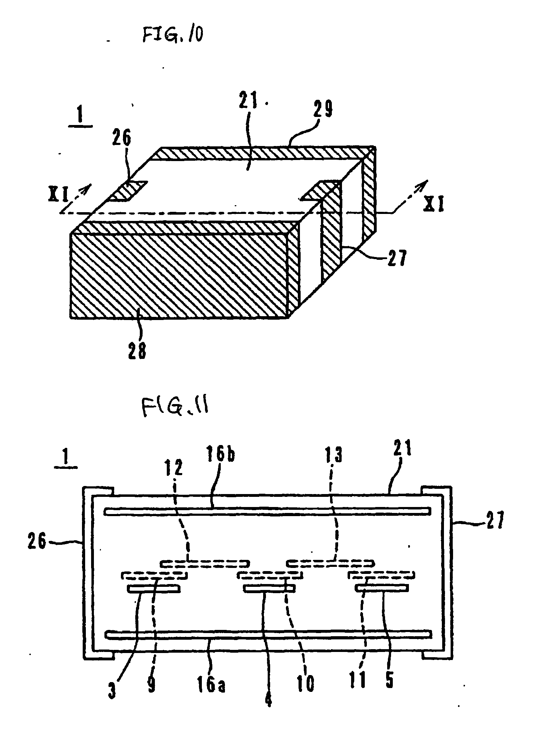

The layered body 21 has an input terminal electrode 26, an output terminal electrode 27, and shielding electrodes 28 and 29 formed as shown in Fig. 10. The input terminal electrode 26 is connected to the input capacitor pattern 14 and the output terminal electrode 27 is connected to the output capacitor pattern 15. The shielding terminal electrode 28 is connected to the lead parts of the inductor patterns 3, 4, and 5 as well as to edge parts of shielding patterns 16a and 16b. The shielding terminal electrode 29 is connected to the lead parts of the capacitor patterns 9 to 11 as well as to the other edge parts of the shielding patterns 16a and 16b.

In the conventional LC filter 1, positions of poles (singular points) in attenuation characteristics cannot be easily adjusted. To change the positions of the poles, the shapes of the inductor patterns 3 to 5, those of the capacitor patterns 9 to 11, and those of the coupling capacitor patterns 12 and 13 and the like must be changed. Therefore, almost all patterns have to be redesigned.

### SUMMARY OF THE INVENTION

Accordingly, it is an object of the present invention to provide a stacked LC filter in which the positions of poles in attenuation characteristics can be easily adjusted.

To achieve the foregoing goals, there is provided a stacked LC filter including a layered body formed by stacking a plurality of insulating layers, a plurality of inductor patterns, and a plurality of capacitor patterns; at least three LC resonators formed in the layered body by a plurality of inductors, which are formed by the inductor patterns, and a plurality of capacitors, which are formed by disposing the capacitor patterns so as to face the inductor patterns; at least two coupling capacitor patterns, stacked in the layered body, for coupling among the LC resonators; and a pole adjusting pattern, stacked in the layered body, facing the at least two coupling capacitor patterns.

By providing a pole adjusting pattern facing at least two coupling capacitor patterns, the positions of poles in attenuation characteristics can be easily adjusted. For example, when the area of the overlapping part between the coupling capacitor patterns and the pole adjusting pattern is increased, an electrostatic capacitance generated between the pole adjusting pattern and the coupling capacitor patterns is increased, which causes the spacing between poles to be wider. On the contrary, when the area of the overlapping part is decreased, the spacing between poles is narrowed. Therefore, a stacked LC filter having superior attenuation characteristics is obtained, which makes it possible to produce a superior duplexer.

In the stacked LC filter, each inductor of each LC resonator may have a multi-layered structure formed by stacking at least two of the inductor patterns having a substantially identical shape, with the insulating layers provided therebetween.

By causing inductors to be multi-layered, magnetic fields generated around the inductors are prevented from being dense at the edge parts of inductor patterns. As a result of this, a stacked LC filter having a superior Q-factor can be obtained.

### BRIEF DESCRIPTION OF THE DRAWINGS

Further objects and advantages of the invention can be more fully understood from the following detailed description of preferred embodiments thereof, given by way of example, taken in conjunction with the accompanying drawings in which:
Fig. 1 is an exploded perspective view showing the construction of a stacked LC filter according to a first embodiment of the present invention;
Fig. 2 is an outer perspective view showing the stacked LC filter shown in Fig. 1;
Fig. 3 is a cross-sectional diagram of the LC filter in Fig. 2 along a line III-III;
Fig. 4 is a graph showing attenuation characteristics of the stacked LC filter shown in Fig. 2;
Fig. 5 is an exploded perspective view showing the construction of a stacked LC filter according to a second embodiment of the present invention;
Fig. 6 is an outer perspective view showing the stacked LC filter shown in Fig. 5;
Fig. 7 is a cross-sectional diagram of the LC filter in Fig. 6 along a line VII-VII;
Fig. 8 is a diagram showing an equivalent circuit of a stacked LC filter;
Fig. 9 is an exploded perspective view showing the construction of a conventional stacked LC filter;
Fig. 10 is an outer perspective view showing the stacked LC filter shown in Fig. 9; and
Fig. 11 is a cross-sectional diagram of the LC filter in Fig. 10 along a line XI-XI.

### DESCRIPTION OF THE PREFERRED EMBODIMENTS

Stacked LC filters according to embodiments of the present invention will now be described with reference to the attached drawings. Although a band-pass filter is used to describe each embodiment, instead, a band-elimination (band-rejection or band stop) filter or the like may be used.

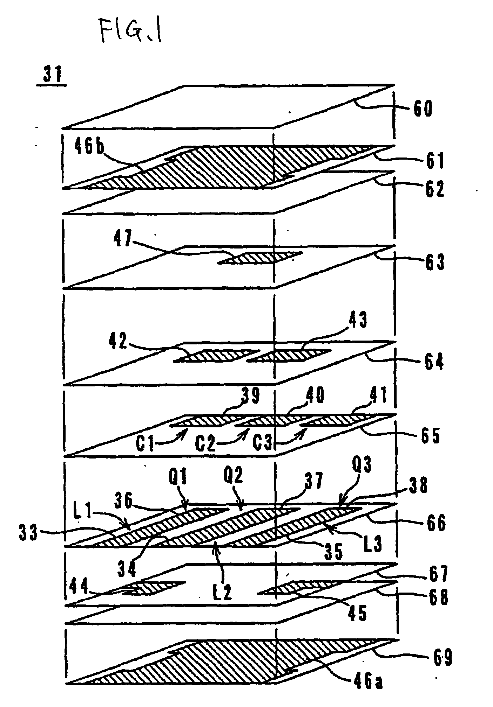

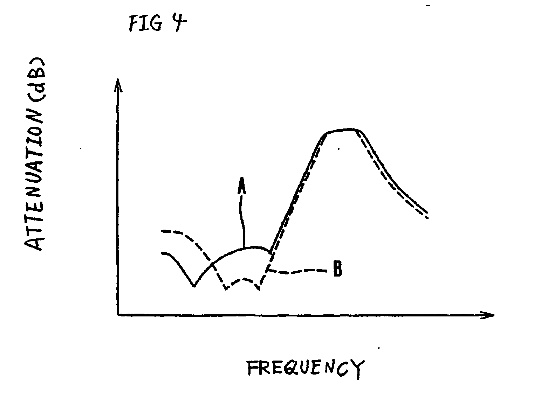

### [First Embodiment (Fig. 1 to Fig. 4)]

One embodiment of the LC filter according to the present invention is shown in Figs. 1 to 3. An LC filter 31 is obtained by applying the present invention to a band-pass filter constituted by first stage to third stage LC resonators Q1 to Q3 shown in Fig. 8. The LC filter 31 according to the first embodiment of the present invention is constructed by providing the first stage to the third stage LC resonators Q1 to Q3 in a layered body 51 constructed by stacking and uniformly sintering quadrangular ceramic sheets 60 to 69 made of barium titanate or the like.

An inductor L1 of the first stage (the initial stage) LC resonator Q1, as shown in Fig. 1, is formed by the inductance of a strip inductor pattern 33. The capacitor C1 of the LC resonator Q1 is constructed by a capacitor pattern 39 and an edge part 36 of the inductor pattern 33 facing, via the sheet 65, the capacitor pattern 39.

An inductor L2 of the second stage LC resonator Q2 is formed by the inductance of a strip inductor pattern 34. A capacitor C2 of the LC resonator Q2 is constructed by a capacitor pattern 40 and an edge part 37 of the inductor pattern 34 facing the capacitor pattern 40.

An inductor L3 of the third stage LC resonator Q3 is formed by the inductance of a strip inductor pattern 35. A capacitor C3 of the LC resonator Q3 is constructed by a capacitor pattern 41 and an edge part 38 of the inductor pattern 35 facing the capacitor pattern 41.

In the above first stage to third stage LC resonators Q1 to Q3, the neighboring LC resonators Q1 and Q2, and the neighboring LC resonators Q2 and Q3 are electrically coupled, respectively, via coupling capacitors Cs1 and Cs2 formed by the capacitor patterns 39 to 41 and coupling capacitor patterns 42 and 43 which face these capacitor patterns 39 to 41 via the sheet 64.

A pole adjusting pattern 47, facing the coupling capacitor patterns 42 and 43, generates electrostatic capacitance between the pole adjusting pattern 47 and the capacitor patterns 42 and 43. Furthermore, the LC resonators Q1 and Q3 are capacitively-coupled with an input capacitor pattern 44 and an output capacitor pattern 45, respectively.

The inductor patterns 33, 34, and 35, which are formed in the left part of, in the middle of, and in the right part of the sheet 66, respectively, have edges thereof exposed at the front side of the sheet 66. The capacitor patterns 39, 40, and 41, which are formed in the left part of, in the middle of, and in the right part of the sheet 65, respectively, have edges thereof exposed at the rear side of the sheet 65. The coupling capacitor patterns 42 and 43 are provided in the vicinity of the rear side of the sheet 64. The pole adjusting pattern 47 is provided in the vicinity of the rear side of the sheet 63. Shielding patterns 46a and 46b are provided so that the above patterns 33 to 35, 39 to 45, and 47 are held therebetween.

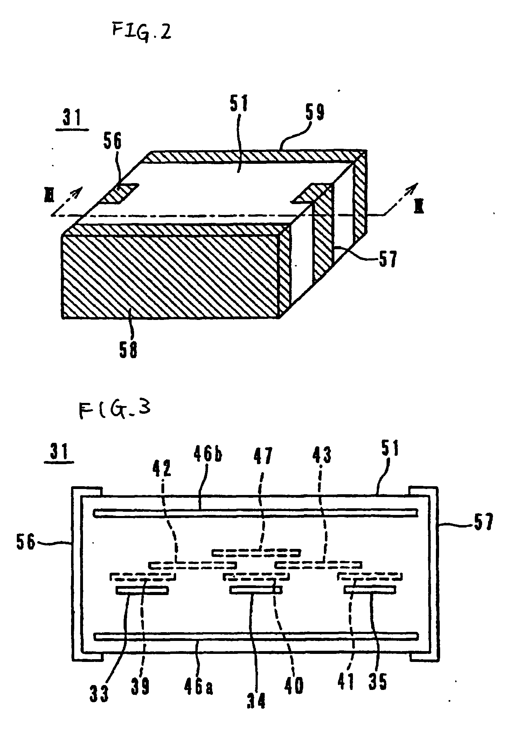

The layered body 51 has an input terminal electrode 56, an output terminal electrode 57, and shielding terminal electrodes 58 and 59 formed, as shown in Fig. 2. The input terminal electrode 56 is connected to the input capacitor pattern 44, and the output terminal electrode 57 is connected to the output capacitor pattern 45. The shielding terminal electrode 58 is connected to the lead parts of the inductor patterns 33, 34, and 35 as well as to one edge part of each of the shielding patterns 46a and 46b. The shielding terminal electrode 59 is connected to the lead parts of the capacitor patterns 39 to 41 as well as to the other edge part of each of the shielding patterns 46a and 46b.

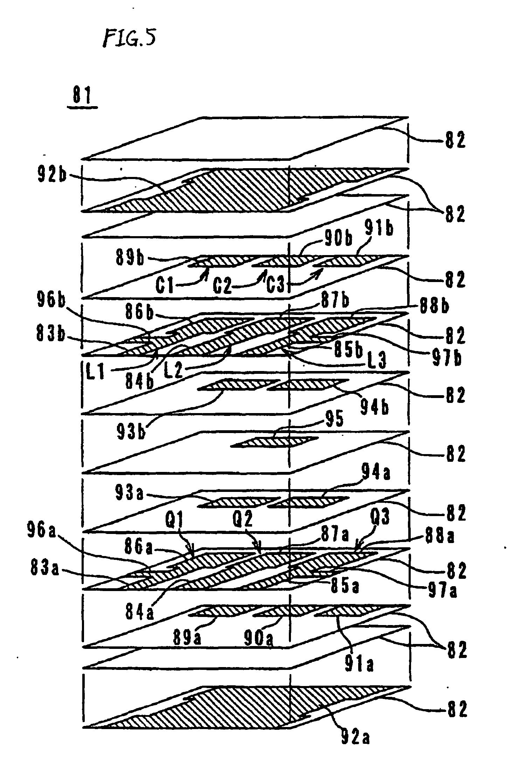

The LC filter 31 having the above construction can adjust the spacing between poles in the LC filter 31 by changing the area of the overlapping part between the pole adjusting pattern 47 and the coupling capacitor patterns 42 and 43. For example, when the area of the overlapping part is large, the capacitance formed by the pole adjusting pattern 47 and the coupling capacitor patterns 42 and 43 becomes large, which, as shown by the solid line A in Fig. 4, leads to attenuation characteristics having a large pole spacing. In contrast, when the area of the overlapping part is small, as shown with the broken line B, attenuation characteristics having a small pole spacing are obtained. Therefore, the LC filter 31 in which the positions of poles in the attenuation characteristics can be easily adjusted can be obtained.

### [Second Embodiment (Fig. 5 to Fig. 7)]

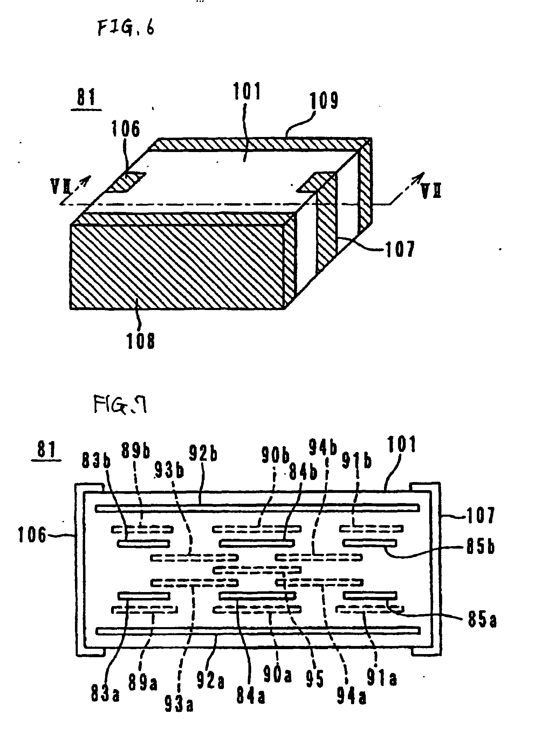

Fig. 5 shows the construction of an LC filter 81. Fig. 6 is a perspective view showing the appearance of the LC filter 81. The LC filter 81 is a three-stage band-pass filter in which the first stage (the initial stage) LC resonator Q1, the second stage LC resonator Q2, and the third stage (the final stage) LC resonator Q3 are connected in series via coupling capacitors Cs1 and Cs2.

As shown in Fig. 5, the LC filter 81 is constituted by ceramic sheets 82 having inductor patterns 83a, 83b, 84a, 85a, and 85b each provided on the surfaces thereof, ceramic sheets 82 having capacitor patterns 89a, 89b, 90a, 90b, 91a, and 91b each provided on the surfaces thereof, ceramic sheets 82 having shielding patterns 92a, and 92b each provided on the surfaces thereof, ceramic sheets 82 having coupling capacitor patterns 93a, 93b, 94a, and 94b each provided on the surfaces thereof, a ceramic sheet 82 having a pole adjusting pattern 95 provided on the surface thereof, and the like.

The inductor patterns 83a and 83b have the same shape. A dual-structure inductor L1 is constructed by stacking the inductor patterns 83a and 83b via ceramic sheets 82. Each of the inductor patterns 83a and 83b, formed in the left part of the sheets 82, have one edge thereof exposed at the front sides of the sheets 82. Other edge parts (wider edge parts) 86a and 86b of the inductor patterns 83a and 83b, respectively, are larger in width. The wider edge parts 86a and 86b (the other edge parts) also function as capacitor patterns. Input-lead patterns 96a and 96b, each extending from the center part of the inductor patterns 83a and 83b, respectively, are exposed at the left sides of ceramic sheets 82.

The inductor patterns 84a and 84b have the same shape. A dual-structure inductor L2 is constructed by stacking the inductor patterns 84a and 84b via ceramic sheets 82. The inductor patterns 84a and 84b are set so as to have a pattern width which is larger by ten percent or more compared with the pattern widths of inductor patterns 83a, 83b, 85a, and 85b. The inductor patterns 84a and 84b formed in the middle of sheets 82 each have an edge thereof exposed at the front sides of the sheets 82. Other edge parts (wider edge parts) 87a and 87b of the inductor patterns 84a and 84b, respectively, are larger in width. The wider edge parts 87a and 87b (the other edge parts) also function as capacitor patterns.

The inductors 85a and 85b have the same shape. A dual-structure inductor L3 is constructed by stacking the inductor patterns 85a and 85b via ceramic sheets 82. Each of the inductor patterns 85a and 85b formed at the righthand part of sheets 82 has one edge thereof exposed at the front sides of the sheets 82. Other edge parts (wider edge parts) 88a and 88b of the inductor patterns 85a and 85b, respectively, are larger in width. The wider edge parts (the other edge parts) 88a and 88b also function as capacitor patterns. Output-lead patterns 97a and 97b, each extending from the central parts of the inductor patterns 85a and 85b, respectively, are exposed at the right sides of the ceramic sheets 82.

The capacitor patterns 89a and 89b are formed in the left parts of the sheets 82 and edges thereof are exposed at the rear sides of the sheets 82. In the stacking direction of the sheets 82, the dual structure inductor L1 constituted by the inductor patterns 83a and 83b is provided between the capacitor patterns 89a and 89b. These capacitor patterns 89a and 89b face the wider edge parts 86a and 86b of the inductor patterns 83a and 83b, whereby the capacitor C1 is formed. The capacitor C1 and the dual-structure inductor L1 form an LC parallel resonant circuit, thereby constituting the first stage LC resonator Q1.

The capacitor patterns 90a and 90b are formed in the middle parts of the sheets 82 and edges thereof are exposed at the rear sides of sheets 82. The dual-structure inductor L2 constituted by the inductor patterns 84a and 84b is provided between the capacitor patterns 90a and 90b. These capacitor patterns 90a and 90b face the wider edge parts 87a and 87b of the inductor patterns 84a and 84b, whereby the capacitor C2 is formed. The capacitor C2 and the dual-structure inductor L2 form an LC parallel resonant circuit, thereby constituting the second stage LC resonator Q2.

The capacitor patterns 91a and 91b are formed in the right parts of the sheets 82 and edges thereof are exposed at the rear sides of sheets 82. The dual-structure inductor L3 constituted by the inductor patterns 85a and 85b is provided between the capacitor patterns 91a and 91b. The capacitor patterns 91a and 91b face the wider edge parts 88a and 88b of the inductor patterns 85a and 85b, whereby the capacitor C3 is formed. The capacitor C3 and the dual-structure inductor L3 form an LC parallel circuit, thereby constituting the third LC resonator Q3.

The coupling capacitor patterns 93a, 93b, 94a, and 94b are provided in the vicinity of the rear sides of the sheets 82, and are provided in the stacking direction of the sheets 82 between the inductor patterns 83a, 84a, and 85a, and the inductor patterns 83b, 84b, and 85b. These coupling capacitors 93a and 93b face the inductor patterns 83a, 83b, 84a, and 84b, whereby the coupling capacitor Cs1 is formed. The coupling capacitor patterns 94a and 94b face the inductor patterns 84a, 84b, 85a, and 85b, whereby the coupling capacitor Cs2 is formed.

The pole adjusting pattern 95 is provided between the coupling capacitor patterns 93a and 94a, and 93b and 94b. This pole adjusting pattern 95 faces the coupling capacitor patterns 93a, 94a, 93b, and 94b, thereby generating a capacitance. The wide shielding patterns 92a and 92b each have an edge exposed at the front sides of the sheets 82, and the other edge exposed at the rear sides of the sheets 82.

By sequentially stacking each sheet 82 having the above construction, as shown in Fig. 5, and uniformly sintering them, a layered body 101, as shown in Fig. 6, is obtained. The layered body 101 has an input terminal electrode 106 and an output terminal electrode 107 formed at the left and right faces of the layered body 101, respectively, as well as shielding terminal electrodes 108 and 109 formed at the front and rear sides of the layered body 101. The input terminal electrode 106 is connected to the input-lead patterns 96a and 96b, and the output terminal electrode 107 is connected to the output-lead patterns 97a and 97b. The shielding terminal electrode 108 is connected to ends of the inductor patterns 83a to 85b and to edges of the shielding patterns 92a and 92b. The shielding terminal electrode 109 is connected to ends of capacitor patterns 89a to 91b and to the other ends of the shielding patterns 92a and 92b.

This LC filter 81 enables the same advantages as obtained with the LC filter 31 in the first embodiment to be achieved. By changing the area of the overlapping parts between the pole adjusting pattern 95 and the coupling capacitor patterns 93a to 94b, the spacing between poles in the attenuation characteristics of the LC filter 81 can be adjusted.

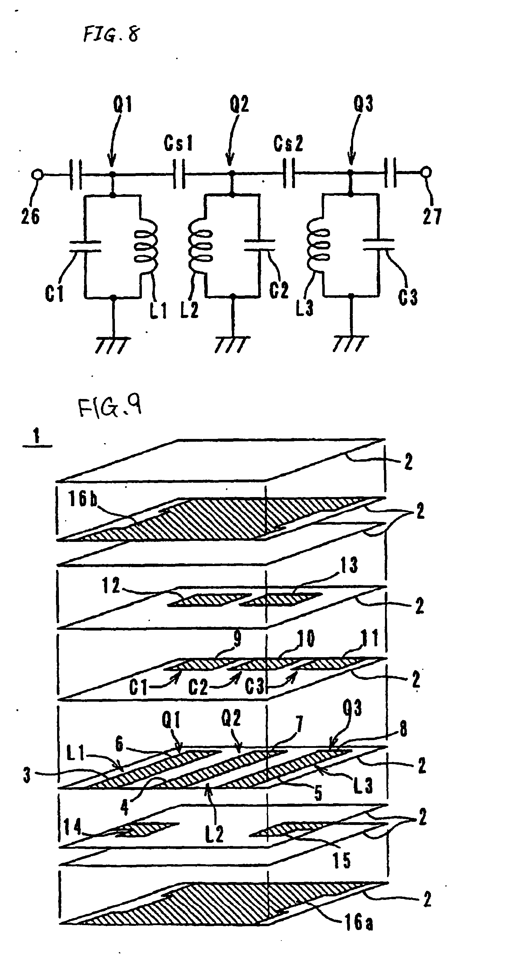

As shown in Fig. 7, in the LC filter 81, magnetic fields H do not occur between the inductor patterns 83a and 83b, between the inductor patterns 84a and 84b, and between the inductor patterns 85a and 85b, which constitute inductors L1 to L3, respectively. Therefore, coupling capacitor patterns 93a to 94b and the pole adjusting pattern 95 provided between inductor patterns 83a, 84a, and 85a, and 83b, 84b, and 85b hardly block magnetic fields generated by the inductors L1 to L3. Accordingly, uniform magnetic fields H are formed, and a large inductance can be obtained.

Since the inductors L1 to L3 have dual (two-layer) structures, by adjusting the spacing between the inductor patterns 83a and 83b, the spacing between the inductor patterns 84a and 84b, and the spacing between the inductor patterns 85a and 85b, the distributions of the magnetic fields H occurring in the periphery of each of the inductors L1 to L3 can be optimized. The magnetic fields H can be prevented from being concentrated at the edge parts of the inductor patterns 83a to 85b.

The inductor patterns 84a and 84b, which constitute the second stage LC resonator Q2 located at the center of the filter 81, have pattern widths which are wider by approximately ten percent or more than the inductor patterns 83a, 83b, 85a, and 85b, which constitute the first and the third stage LC resonators Q1 and Q3 located at both ends of the filter 81. Therefore, magnetic fields H in the edge parts of the inductor patterns 84a and 84b can be further decreased. Thus, the LC filter 81 having a superior Q-factor can be obtained.

### [Other Embodiments]

Stacked LC filters according to the present invention are not limited to the foregoing embodiments. Various modifications can be made within the scope of the present invention as expressed in the annexed claims. For example, the stacked LC filter may have more than three LC resonators.

Furthermore, although in the foregoing embodiments, stacked LC filters are constructed by stacking ceramic sheets each having patterns formed thereon then uniformly sintering the stacked ceramic sheets, the present invention is not necessarily limited to this method. The ceramic sheets may be pre-sintered. LC filters may be constructed using a method described below. After a ceramic layer is formed with pasty ceramic materials by printing or the like, an arbitrary pattern is formed by coating pasty conductive pattern materials on the surface of the ceramic layer. Then by coating pasty ceramic materials on the above pattern, the ceramic layers containing the pattern are obtained. Likewise, by sequentially repeating the re-coating process, an LC filter having a layered structure is obtained.

## Claims

1. A stacked LC filter comprising:
a layered body (31) formed by stacking on each other a plurality of insulating layers (60-69), a plurality of inductor patterns (33-35), and a plurality of capacitor patterns (39-41);
the inductor patterns (33-35) and the capacitor patterns (39-41) each provided on the surfaces of the insulating layers (60-69)
at least three LC resonators (Q1-Q3) formed in said layered body by a plurality of inductors (L1-L3), which are formed by the inductor patterns (33-35), and a plurality of capacitors (C1-C3), which are formed by disposing the capacitor patterns (39-41) so as to face the inductor patterns (33-35) in the stacking direction;
at least two coupling capacitor patterns (42,43), stacked in said layered body, for coupling among the LC resonators (Q1-Q3); and
a pole adjusting pattern (47), stacked in said layered body, facing said at least two coupling capacitor patterns (42,43) in the stacking direction, and thereby generating electrostatic capacitance between the pole adjusting pattern (47) and the at least two coupling capacitor patterns (42, 43).

2. A stacked LC filter (81) according to Claim 1, wherein each inductor (L1/L2/L3) of each LC resonator has a multi-layered structure formed by stacking at least two (83a,b/84a,b/85a,b) of said inductor patterns having a substantially identical shape, with the insulating layers (82) provided therebetween.

## Patentansprüche

1. Ein gestapeltes LC-Filter, das folgende Merkmale aufweist:
einen Schichtkörper (31), der durch ein Aufeinanderstapeln einer Mehrzahl von Isolierschichten (60-69), einer Mehrzahl von Induktorstrukturen (33-35) und einer Mehrzahl von Kondensatorstrukturen (39-41) gebildet ist; wobei die Induktorstrukturen (33-35) und die Kondensatorstrukturen (39-41) jeweils auf den Oberflächen der Isolierschichten (60-69) vorgesehen sind;
zumindest drei LC-Resonatoren (Q1-Q3), die in dem Schichtkörper durch eine Mehrzahl von Induktoren (L1-L3), die durch die Induktorstrukturen (33-35) gebildet sind, und eine Mehrzahl von Kondensatoren (C1-C3) gebildet sind, die durch ein Anordnen der Kondensatorstrukturen (39-41), um den Induktorstrukturen (33-35) in der Stapelrichtung zugewandt zu sein, gebildet sind;
zumindest zwei Kopplungskondensatorstrukturen (42, 43), die in dem Schichtkörper gestapelt sind, für eine Kopplung zwischen den LC-Resonatoren (Q1-Q3); und
eine Poleinstellungsstruktur (47), die in dem Schichtkörper gestapelt ist und die den zumindest zwei Kopplungskondensatorstrukturen (42, 43) in der Stapelrichtung zugewandt ist und **dadurch** eine elektrostatische Kapazität zwischen der Poleinstellungsstruktur (47) und den zumindest zwei Kopplungskondensatorstrukturen (42, 43) erzeugt.

2. Ein gestapeltes LC-Filter (81) gemäß Anspruch 1, bei dem jeder Induktor (L1/L2/L3) jedes LC-Resonators eine Mehrschichtstruktur aufweist, die durch ein Stapeln von zumindest zwei (83a,b/84a,b/85a,b) der Induktorstrukturen, die eine im Wesentlichen identische Form aufweisen, gebildet ist, wobei die Isolierschichten (82) zwischen denselben vorgesehen sind.

## Revendications

1. Filtre LC à empilement comportant :
un corps stratifié (31) formé en empilant l'un sur l'autre une pluralité de couches isolantes (60-69), une pluralité de motifs d'inductance (33-35), et une pluralité de motifs de condensateur (39-41), les motifs d'inductance (33-35) et les motifs de condensateur (39-41) étant prévus chacun sur les surfaces des couches isolantes (60-69) ;
au moins trois résonateurs LC (Q1-Q3) formés dans ledit corps stratifié par une pluralité d'inductances (L1-L3), qui sont formés par les motifs d'inductance (33-35), et une pluralité de condensateurs (C1-C3), qui sont formés en disposant les motifs de condensateur (39-41) en vis-à-vis des motifs d'inductance (33-35) dans la direction d'empilement ;
au moins deux motifs de condensateur de couplage (42, 43), empilés dans ledit corps stratifié, pour un couplage entre les résonateurs LC (Q1-Q3) ; et
un motif d'ajustement de pôle (47), empilé dans ledit corps stratifié, en vis-à-vis desdits au moins deux motifs de condensateur de couplage (42, 43) dans la direction d'empilement, et générant ainsi une capacité électrostatique entre le motif d'ajustement de pôle (47) et les au moins deux motifs de condensateur de couplage (42, 43).

2. Filtre LC à empilement (81) selon la revendication 1, dans lequel chaque inductance (L1/L2/L3) de chaque résonateur LC présente une structure à couches multiples formée en empilant au moins deux (83a,b/84a,b/85a,b) desdits motifs d'inductance présentant une forme sensiblement identique, les couches isolantes (82) étant prévues entre eux.
